Europäisches Patentamt

European Patent Office

Office européen des brevets

(11) Veröffentlichungsnummer: **0 314 947**

**A1**

## (12) EUROPÄISCHE PATENTANMELDUNG

(21) Anmeldenummer: 88116930.4

(22) Anmeldetag: 12.10.88

(51) Int. Cl.⁴: **H01J 37/28 , H01J 37/147**

(30) Priorität: 03.11.87 DE 3737287

(43) Veröffentlichungstag der Anmeldung:
10.05.89 Patentblatt 89/19

(84) Benannte Vertragsstaaten:
**DE FR GB NL**

(71) Anmelder: **Siemens Aktiengesellschaft Berlin
und München
Wittelsbacherplatz 2
D-8000 München 2(DE)**

(72) Erfinder: **Schmitt, Reinhold, Dipl.-Ing.
Josef-Kiefer-Weg 6
D-8000 München 83(DE)**

(54) **Schaltung zur vergrösserungsunabhängigen Bildverschiebung in einem Korpuskularstrahlgerät.**

(57) Die erfindungsgemäße Schaltung umfaßt einen gegengekoppelten Stromverstärker (OV), an dessen Eingang ein sägezahnförmiges Ablenksignal ($U_S$) anliegt, ein Spulenpaar (SC) zur Ablenkung des Korpuskularstrahls (PE) eines Rastermikroskops innerhalb des durch den Spulenstrom (i) vorgegebenen Abtastfeldes (RF), mehrere über einen Schalter (S) auswählbare Widerstandselemente ($R_M$) und eine Konstantstromquelle ($U_v$, W), die den die Bildverschiebung bewirkenden Gleichstrom ($i_o$) in die Verbindung (P) zwischen dem Spulenpaar (SC) und dem jeweiligen Widerstandselement ($R_M$) einspeist. Da dieser Gleichstrom ($i_o$) aufgrund der Rückkopplung des Verstärkers (OV) nur über die Spulen (SC), aber nicht über die Widerstandselemente ($R_M$) fließen kann, ist die Bildverschiebung unabhängig von der durch das jeweilige Widerstandselement ($R_M$) vorgegebenen Vergrößerung (V).

FIG 2

EP 0 314 947 A1

## Schaltung zur vergröß erungsunabhängigen Bildverschiebung in einem Korpuskularstrahlgerät

Die Erfindung betrifft eine Schaltung zur vergrößerungsunabhängigen Bildverschiebung in einem Korpuskularstrahlgerät nach dem Oberbegriff des Patentanspruchs 1.

Zur vergrößerten Abbildung einer Probe in einem Rasterelektronenmikroskop wird deren Oberfläche zeilenweise mit einem Elektronenstrahl abgetastet. Dieser löst auf der Probe Sekundärelektronen aus, deren Anzahl u. a. von der an der Auftreffstelle vorliegenden Materialzusammensetzung und der Oberflächenstruktur abhängt. Die Stärke des von der Probe ausgehenden und durch den Material- und Topographiekontrast modulierten Sekundärelektronenstroms wird in einem Detektor gemessen, dessen Ausgangssignal die Intensität eines synchron mit dem Elektronenstrahl abgelenkten Schreibstrahls eines Monitors steuert.

In einem Rasterelektronenmikroskop überstreicht die durch das Verhältnis

$$V = \frac{\text{Zeilenlänge auf dem Monitorbildschirm}}{\text{Zeilenlänge auf der Probenoberfläche}} \quad 1)$$

definierte und über den in den Ablenkspulen fließenden Strom einstellbare Vergrößerung V mehrere Größenordnungen. Um den Ablenkstrom und damit die Vergrößerung in dem gewünschten Bereich wählen zu können, verwendet man üblicherweise gegengekoppelte Stromverstärker, die ihr Signal von in mehreren Stufen umschaltbaren Meßwiderständen ableiten. Zur elektrischen Bildverschiebung, d. h. zur Verschiebung des Rasterfeldes auf der Probenoberfläche, muß dem Feld der Ablenkspulen ein einstellbares Gleichfeld überlagert werden. Die einfachste Lösung, das gewünschte Gleichfeld durch eine Addition einer Gleichspannung auf den Eingang des Stromverstärkers zu erzeugen hat den Nachteil, daß die Bildverschiebung dann von der jeweils eingestellten Vergrößerung V abhängt. In bekannten Anordnungen ist man deshalb gezwungen, die Gleichspannung oder deren Einspeisung bei jeder Umschaltung der Meßwiderstände entsprechend zu ändern. Dies ist technisch aufwendig und nicht immer exakt durchführbar, so daß sprunghafte Bildverschiebungen beim Umschalten der Vergrößerung auftreten.

Der Erfindung liegt die Aufgabe zugrunde, eine Schaltung der eingangs genannten Art anzugeben, bei der die Bildverschiebung unabhängig von der gewählten Vergrößerung ist. Diese Aufgabe wird durch eine Schaltung nach Patentanspruch 1 gelöst.

Der mit der Erfindung erzielbare Vorteil besteht insbesondere darin, daß sprunghafte Bildverschiebungen beim Umschalten der Vergrößerung vermieden werden.

Die Ansprüche 2 bis 5 betreffen bevorzugte Ausgestaltungen der Schaltung nach Anspruch 1, die nachfolgend anhand der Zeichnungen näher erläutert wird.

Hierbei zeigt:

FIG 1 eine bekannte Schaltung zur Bildverschiebung in einem Rasterelektronenmikroskop,

FIG 2 eine erfindungsgemäße Schaltung zur vergrößerungsunabhängigen Bildverschiebung in einem Rasterelektronenmikroskop.

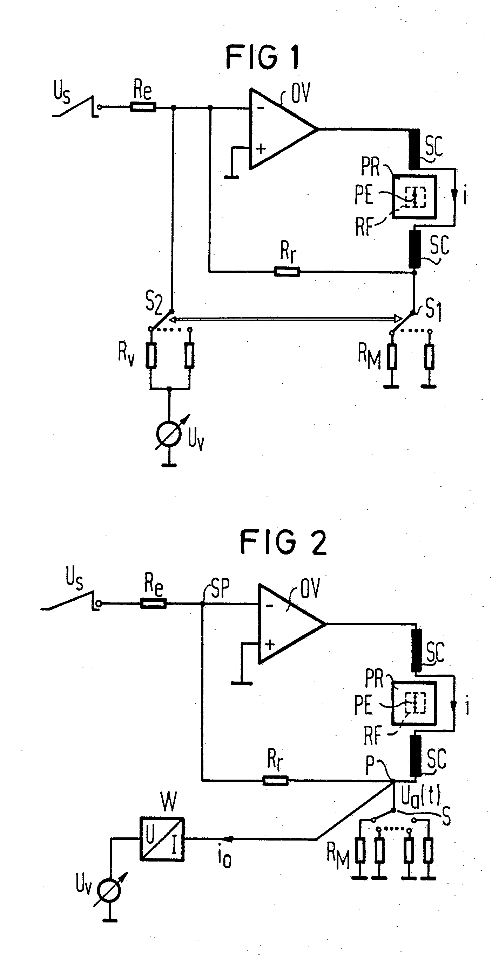

Die in FIG 1 schematisch dargestellte Schaltung zur vergrößerungsunabhängigen Bildverschiebung in einem Rasterelektronenmikroskop umfaßt einen gegengekoppelten Stromverstärker, ein Spulenpaar SC zur Ablenkung des Elektronen strahls PE auf der Probe PR, mehrere über einen Schalter S1 auswählbare Meßwiderstände $R_M$ zur Einstellung der Größe des Rasterfeldes RF auf der Probenoberfläche und eine Spannungsquelle $U_V$, deren von außen vorgegebene Gleichspannung über einen der Widerstände $R_V$ dem am invertierenden Eingang des Operationsverstärkers OV anliegenden sägezahnförmigen Ablenksignal $U_S$ überlagert wird. Da das im Strahlengang der Primärelektronen mit Hilfe der Ablenkeinheit aufgebaute Magnetfeld die Ablenkung des Elektronenstrahls PE auf der Probenoberfläche bestimmt, kann die Größe des Rasterfeldes RF in der durch den Pfeil vorgegebenen Richtung über den in den Spulen SC fließenden Strom eingestellt werden. Für den Betrag der Stromstärke i gilt hierbei die Beziehung

$$i = \{R_{r'}/(R_e \cdot R_M)\} U_S + \{R_{r'}/(R_v \cdot R_M)\} U_v := i_S + i_B, \quad 2)$$

wobei $i_S$ die Größe des Rasterfeldes RF in der durch das Spulenfeld vorgegebenen Richtung und $i_B$ die über die Spannungsquelle $U_V$ einstellbare Bildverschiebung in Ablenkrichtung, d. h. die Lage des Abtastfeldes RF auf der Probe PR definiert. Wie Gleichung 2) zeigt, ist der die Bildverschiebung bewirkende Gleichstrom $i_B$ auch von dem über den Schalter S1 ausgewählten Meßwiderstand $R_M$ abhängig. Um eine von der Vergrößerung V, d. h. von dem jeweiligen Meßwiderstand $R_M$ unabhängige Bildverschiebung zu gewährleisten ist man gezwungen, den Widerstand $R_V$ mit Hilfe des an $S_1$ gekoppelten Schalters $S_2$ derart bei einem Vergrößerungswechsel umzuschalten, daß das Produkt $R_V \cdot R_M$ und damit der Gleichstrom $i_B$ den vorgegebenen Wert beibehält.

Eine erfindungsgemäße Schaltung zur vergrößerungsunabhängigen Bildverschiebung in einem Rasterelektronenmikroskop ist schematisch in FIG 2 dargestellt. Die Schaltung umfaßt einen gegengekoppelten Operationsverstärker OV, an dessen invertierenden Eingang das sägezahnförmige Ablenk signal $U_S$ anliegt, ein beispielsweise aus dem Lehrbuch von L. Reimer Scanning Electron Microscopy, Springer Series in Optical Sciences, Vol. 45, Seite 36-40, insbesondere S. 38, Fig. 2.18 bekanntes Spulenpaar SC zur Ablenkung des Elektronenstrahls PE innerhalb des durch den Spulenstrom vorgegebenen Abtastfeldes RF auf der Probenoberfläche, mehrere über einen mechanischen oder elektronischen Schalter S auswählbare Meßwiderstände $R_M$ und eine aus einer Spannungsquelle $U_V$ und einem Spannungs-Strom-Wandler W bestehende regelbare Konstantstromquelle, die den die Bildverschiebung bewirkenden Gleichstrom $i_o$ am Punkt P in die Verbindung zwischen den Spulen SC und dem jeweiligen Meßwiderstand $R_M$ einspeist. Durch die Spulen SC fließt dann ein Strom, dessen Stärke i dem Betrag nach durch

$$i = \{R_r/(R_e \cdot R_M)\}\ U_S + i_o : = i_S + i_o \qquad 3)$$

gegeben ist, wobei $i_S$ wieder die Größe des Rasterfeldes RF und $i_o$ dessen Lage auf der Probenoberfläche definiert. Die Addition des Gleichstroms $i_o$ und des zeitlich veränderlichen Stroms $i_s$ ist zulässig, da das Potential $U_a = R_r/R_e)\ U_s(t)$ des Punktes P aufgrund der Rückkopplung des Verstärkers OV (der Summierpunkt SP des Operationsverstärkers OV liegt trotz des zeitabhängigen Eingangssignals $U_S(t)$ auf virtueller Masse) keine Gleichspannungskomponente enthält. Dies bedeutet, daß der Strom $i_o$ nicht über die Widerstände $R_M$ und $R_r$, sondern nur über die Spulen SC in den Ausgang des Operationsverstärkers OV fließen kann. Dieser Vorgang ist unabhängig von dem über den Schalter S jeweils ausgewählten Meßwiderstand $R_M$ und damit unabhängig von der gewählten Vergrößerung V.

Die Widerstände der Schaltung nach FIG 2 können beispielsweise wie folgt dimensioniert werden:
$R_e = 1\ M\Omega$
$R_r = 100\ k\Omega$
$R_M = 1\ \Omega$ bis $100\ k\Omega$

Mit der Schaltung nach FIG 2 kann das Abtastfeld nur in der durch den Pfeil angegebenen Richtung verlagert werden. Zur Verschiebung des Abtastfeldes in einer beliebigen Richtung ist eine entsprechend der beschriebenen Schaltung ausgebildete zweite Schaltung mit einem um 90° gedrehten Spulenpaar notwendig.

Die Erfindung ist selbstverständlich nicht auf das beschriebene Ausführungsbeispiel beschränkt. So kann der gegengekoppelte Operationsverstärker OV auch durch einen anderen Stromverstärker ersetzt werden. Außerdem können anstelle der Meßwiderstände $R_M$ auch elektronische Widerstandselemente, beispielsweise Mosfets, verwendet werden.

Die erfindungsgemäße Schaltung kann außer in Rasterelektronenmikroskopen selbstverständlich auch in Elektronenstrahlmeßgeräten und Rasterionenmikroskopen verwendet werden.

**Ansprüche**

1. Schaltung zur vergrößerungsunabhängigen Bildverschiebung in einem Korpuskularstrahlgerät mit einem gegengekoppelten Stromverstärker (OV), der eingangsseitig mit einem zeitabhängigen Signal ($U_S$) zur Ablenkung eines Korpuskularstrahls (PE) beaufschlagt ist und dessen Ausgangssignal an einem Eingang einer Ablenkeinheit (SC) des Korpuskularstrahlgerätes anliegt und mit einer Schaltung (S, $R_M$) zur Änderung der Verstärkung (V) des Stromverstärkers (OV), deren Eingang mit einem Ausgang der Ablenkeinheit (SC) verbunden ist, **gekennzeichnet** durch eine Konstantstromquelle ($U_V$, W), deren Strom ($i_o$) in die Verbindung (P) zwischen dem Ausgang der Ablenkeinheit (SC) und dem Eingang der Schaltung (S, $R_m$) zur Änderung der Verstärkung (V) eingespeist wird.

2. Schaltung nach Anspruch 1, **gekennzeichnet** durch einen Operationsverstärker (OV) als Stromverstärker.

3. Schaltung nach Anspruch 1 oder 2, **gekennzeichnet** durch mehrere über einen Schalter (S) auswählbare Widerstandselemente ($R_M$) als Schaltung zur Änderung der Verstärkung (V).

4. Schaltung nach einem der Ansprüche 1 bis 3, **gekennzeichnet** durch eine Spannungsquelle ($U_V$) und einen Spannungs-Strom-Wandler (W) als Konstantstromquelle.

5. Schaltung nach einem der Ansprüche 1 bis 4, **gekennzeichnet** durch ein Spulenpaar (SC) als Ablenkeinheit.

## FIG 1

## FIG 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | PATENT ABSTRACTS OF JAPAN, Band 9, Nr. 81 (E-307)[1804], 10. April 1985; & JP-A-59 214 149 (HITACHI SEISAKUSHO K.K.) 04-12-1984 --- | 1 | H 01 J 37/28 H 01 J 37/147 |
| A | PATENT ABSTRACTS OF JAPAN, Band 9, Nr. 15 (E-291)[1738], 22. Januar 1985; & JP-A-59 165 358 (NIPPON DENKI K.K.) 18-09-1984 ----- | 1 | |

RECHERCHIERTE
SACHGEBIETE (Int. Cl.4)

H 01 J 37/00

Der vorliegende Recherchenbericht wurde für alle Patentansprüche erstellt

| Recherchenort | Abschlußdatum der Recherche | Prüfer |
|---|---|---|
| DEN HAAG | 01-02-1989 | SCHAUB G.G. |